# EUROPEAN PATENT APPLICATION

(11) **EP 3 211 441 A1**
(43) Date of publication of application: **30.08.2017**
(21) Application number: 16777886.9
(22) Date of filing: 04.07.2016
(51) Int. Cl.: G01R 31/36

(54) **METHOD AND SYSTEM FOR MEASURING BATTERY POWER OF MOBILE COMMUNICATION TERMINAL DEVICE**

(30) Priority: 30.12.2015 CN 201511023851
(71) Applicant: Le Holdings (Beijing) Co., Ltd., Beijing 100025 (CN); Lemobile Information Technology (Beijing) Co., Ltd., Beijing 101300 (CN)
(72) Inventor: ZHOU, Zhongqian, Beijing 101300 (CN)
(74) Representative: Thoma, Michael
(86) International application number: PCT/CN2016/088318
(87) International publication number: WO 2017/113675

(57) **Abstract**

The present invention discloses a method and system for measuring quantity of electric charge of battery of mobile communication terminal equipment. The method includes: obtaining an operating state and related parameters of a radio frequency module; determining a measuring time of a battery voltage according to the operating state and the related parameters; measuring the battery voltage to obtain a basic voltage value at the measuring time; compensating the basic voltage value to obtain a compensated voltage value according to the operating state and the related parameters; and obtaining the quantity of electric charge of battery according to the compensated voltage value.

## Description

This application is based upon and claims priority to Chinese Patent Application No. 201511023851.9, filed on December 30, 2015, titled " METHOD AND SYSTEM FOR MEASURING QUANTITY OF ELECTRIC CHARGE OF BATTERY OF MOBILE COMMUNICATION TERMINAL EQUIPMENT", and the entire contents of which are incorporated herein by reference.

### TECHNICAL FIELD

The present invention relates to the field of electronic measurement technology, and specifically relates to a method and system for measuring quantity of electric charge of battery of mobile communication terminal equipment.

### BACKGROUND

There are mainly two types of methods for measuring the quantity of electric charge of battery, namely a voltage measurement method and a coulometer method. The coulometer method has high precision but needs a special circuit for implementation, and thus is complex, and is high in cost. At present, the most popular, simplest, most convenient and fastest method for measuring the quantity of electric charge of battery is the voltage measurement method: the quantity of electric charge of battery is derived by measuring the voltage between two poles of a battery and using a relation curve between the quantity of electric charge of battery and the battery voltage. Therefore, the accuracy of the quantity of electric charge of battery is very important for correctly estimating the battery remaining capacity.

The relation curve between the quantity of electric charge of battery and the battery voltage given by a battery manufacturer is actually the relation curve between the quantity of electric charge of battery and a battery open circuit voltage, which is an ideal curve obtained in the case without any battery load. The battery voltage measured in practical application is greatly influenced by the battery load, and most quantity of electric charge of battery measuring technologies based on voltage at present generally make various compensation treatments on the basis that the battery voltage is measured to remove battery voltage instability so as to improve the accuracy in the measurement of quantity of electric charge of battery. For example, the Chinese patent application CN201310594575.6 discloses a method for measuring quantity of electric charge of battery, in which the influences of power consuming devices including an LCD backlight, a CPU, a GPU and the like on the battery voltage, the compensation voltage of each power consuming device is calculated, and the quantity of electric charge of battery is obtained according to the compensated voltage. However, such type of the conventional compensation technologies can only meet the measurement requirements of the quantity of electric charge of battery of common terminal equipment, and for the mobile communication terminal equipment, it cannot obtain an accurate quantity of electric charge of battery measurement result, so that it is possible to result in that the equipment cannot be used normally, and it may also result in a too long charging time or insufficient charging in a recharging process.

### SUMMARY

The present invention aims to solve the technical problem that the quantity of electric charge of battery of mobile communication terminal equipment cannot be accurately measured in the prior art.

Thus, the embodiments of the present invention provides a method for measuring quantity of electric charge of battery of mobile communication terminal equipment, including: obtaining an operating state and related parameters of a radio frequency module; determining a measuring time of a battery voltage according to the operating state and the related parameters; measuring the battery voltage to obtain a basic voltage value at the measuring time; compensating the basic voltage value to obtain a compensated voltage value according to the operating state and the related parameters; and obtaining the quantity of electric charge of battery according to the compensated voltage value.

Preferably, the radio frequency module is a radio frequency transceiver.

Preferably, the step of determining the measuring time of the battery voltage according to the operating state and the related parameters includes: when the operating state indicates that a transmitting unit of the radio frequency transceiver is ready to transmit a signal, calculating the measuring time t_{VM} (t_{TX}<t_{VM}<t_{TX}+D_{TX}) of the battery voltage for each transmitting time slot respectively, wherein t_{TX} represents the transmitting start time of each transmitting time slot, and D_{TX} represents a transmitting duration; when the operating state indicates that a receiving unit of the radio frequency transceiver is ready to receive a signal, calculating the measuring time t_{VM} (t_{RX}<t_{VM}<t_{TX}+D_{RX}) of the battery voltage for each transmitting time slot, wherein t_{RX} represents the receiving start time of each receiving time slot, and D_{RX} represents a receiving duration; and when the operating state indicates that the transmitting unit and the receiving unit of the radio frequency transceiver are ready to respectively transmit and receive signals at the same time, calculating a first measuring time t_{VM1} (t_{TX}<t_{VM1}<t_{TX}+D_{TX}) of the battery voltage for each transmitting time slot, calculating a second measuring time t_{VM2} (t_{RX}<t_{VM2}<t_{TX}+D_{RX}) of the battery voltage for each transmitting time slot, determining the time order of the first measuring time t_{VM1} and the second measuring time t_{VM2}, and taking the earlier one of them as the measuring time of the battery voltage.

Preferably, the step of compensating the basic voltage value to obtain the compensated voltage value includes: when the basic voltage value is obtained under the condition that the transmitting unit of the radio frequency transceiver is in operation, determining the compensated voltage value V_{C}=V₀+ΔV_{TX}(P_{TX}); when the basic voltage value is obtained under the condition that the receiving unit of the radio frequency transceiver is in operation, determining the compensated voltage value V_{C}=V₀+ΔV_{RX}(G_{RX}); and when the basic voltage value is obtained under the condition that both of the transmitting unit and the receiving unit of the radio frequency transceiver are in operation, determining the compensated voltage value V_{C}=V₀+ΔV_{TX}(P_{TX}) +ΔV_{RX}(G_{RX}), wherein V₀ represents the basic voltage value, ΔV_{TX}(P_{TX}) represents a compensation voltage related to a transmitting frequency P_{TX} of the radio frequency transceiver, and ΔV_{RX}(G_{RX}) represents a compensation voltage related to a receive gain G_{RX} of the radio frequency transceiver.

Preferably, between the step of measuring the battery voltage to obtain a basic voltage value and the step of compensating the basic voltage value to obtain a compensated voltage value, the method further includes: updating the basic voltage value according to conventional influence factors.

The embodiment of the present invention further provides a system for measuring quantity of electric charge of battery of mobile communication terminal equipment, including: one or more processors, a memory, one or more programs, stored in the memory, and when executed by the one or more processors perform the following steps of obtaining an operating state and related parameters of a radio frequency module; determining a measuring time of a battery voltage according to the operating state and the related parameters; measuring the battery voltage to obtain a basic voltage value at the measuring time; compensating the basic voltage value to obtain a compensated voltage value according to the operating state and the related parameters; and obtaining the quantity of electric charge of battery according to the compensated voltage value.

Preferably, the radio frequency module is a radio frequency transceiver.

Preferably, the step of determining the measuring time of the battery voltage according to the operating state and the related parameters includes: when the operating state indicates that a transmitting unit of the radio frequency transceiver is ready to transmit a signal, calculating the measuring time t_{VM} (t_{TX}<t_{VM}<t_{TX}+D_{TX}) of the battery voltage for each transmitting time slot respectively, wherein t_{TX} represents the transmitting start time of each transmitting time slot, and D_{TX} represents a transmitting duration; when the operating state indicates that a receiving unit of the radio frequency transceiver is ready to receive a signal, calculating the measuring time t_{VM} (t_{RX}<t_{VM}<t_{TX}+D_{RX}) of the battery voltage for each transmitting time slot, wherein t_{RX} represents the receiving start time of each receiving time slot, and D_{RX} represents a receiving duration; and when the operating state indicates that the transmitting unit and the receiving unit of the radio frequency transceiver are ready to respectively transmit and receive signals at the same time, calculating a first measuring time t_{VM1} (t_{TX}<t_{VM1}<t_{TX}+D_{TX}) of the battery voltage for each transmitting time slot calculating a second measuring time t_{VM2} (t_{RX}<t_{VM2}<t_{TX}+D_{RX}) of the battery voltage for each transmitting time slot, determining the time order of the first measuring time t_{VM1} and the second measuring time t_{VM2}, and taking the earlier one of them as the measuring time of the battery voltage.

Preferably, the step of compensating the basic voltage value to obtain the compensated voltage value includes: when the basic voltage value is obtained under the condition that the transmitting unit of the radio frequency transceiver is in operation, determining the compensated voltage value V_{C}=V₀+ΔV_{TX}(P_{TX}); when the basic voltage value is obtained under the condition that the receiving unit of the radio frequency transceiver is in operation, determining the compensated voltage value V_{C}=V₀+ΔV_{RX}(G_{RX}); and when the basic voltage value is obtained under the condition that both of the transmitting unit and the receiving unit of the radio frequency transceiver are in operation, determining the compensated voltage value V_{C}=V₀+ΔV_{TX}(P_{TX}) +ΔV_{RX}(G_{RX}), wherein V₀ represents the basic voltage value, ΔV_{TX}(P_{TX}) represents a compensation voltage related to a transmitting frequency P_{TX} of the radio frequency transceiver, and ΔV_{RX}(G_{RX}) represents a compensation voltage related to a receive gain G_{RX} of the radio frequency transceiver.

Preferably, between the step of measuring the battery voltage to obtain a basic voltage value and the step of compensating the basic voltage value to obtain a compensated voltage value, the programs further perform the step of updating the basic voltage value according to conventional influence factors.

According to a method and system for measuring the quantity of electric charge of battery of the mobile communication terminal equipment, provided by embodiments of the present invention, a measuring time of the battery voltage is determined according to the operating state and the related parameters of the radio frequency module, a basic voltage value is obtained by measuring at the measuring time, and a compensated voltage value is obtained according to the operating state and the related parameters of the radio frequency module to compensate the influence of the radio frequency module on the fluctuation of the battery voltage, so that the quantity of electric charge of battery of the mobile communication terminal equipment can be accurately obtained.

### BRIEF DESCRIPTION OF THE DRAWINGS

It will be more clear to understand the features and advantages with reference to the accompany drawings, which are presented schematically but shall not be deemed as limitation to the present invention, in which
Fig. 1 shows a flow diagram of a method for measuring the quantity of electric charge of battery of mobile communication terminal equipment according to an embodiments of the present invention;
Fig. 2 shows a flow diagram of a preferred embodiment of a method for measuring the quantity of electric charge of battery of mobile communication terminal equipment according to an embodiments of the present invention;
Fig. 3 shows a schematic diagram of the system for measuring the quantity of electric charge of battery of mobile communication terminal equipment according to an embodiments of the present invention;
Fig. 4 shows a schematic diagram of a system with one processor for measuring the quantity of electric charge of battery of mobile communication terminal equipment according to an embodiments of the present invention; and
Fig. 5 shows a schematic diagram of a system with two processors for measuring the quantity of electric charge of battery of mobile communication terminal equipment according to an embodiments of the present invention.

### DETAILD DESCRIPION OF THE EMBODIMENTS

A clear and complete description of the technical solutions in the present invention will be given below, in conjunction with the accompanying drawings in the embodiments of the present invention. Apparently, the embodiments described below are a part, but not all, of the embodiments of the present invention. All of other embodiments, obtained by those of ordinary skill in the art based on the embodiments of the present invention without any creative effort, fall into the protection scope of the present invention.

In the description of the present invention, it needs to be noted that, the terms such as "center", "above", "below", "left", "right", "vertical", "horizontal", "outside" refer to the orientation or position relation based on the illustration of the drawings, and merely for facilitating and simplifying the description of the present invention, but not indicating or implying that the apparatus or components must have a specific orientation, or a specific configuration and operation. Thus, it should be understood as a limitation to the present invention. In addition, the terms such as "first", "second", "third" are merely for the purpose of description, but should not be understood as an indication or implication of relative importance.

In the description of the present invention, it needs to be noted that, unless specifically defined or restricted otherwise, terms "mount", "interconnect", "connect" should be broadly construed, for example, they may be fixed connection or detachable connection or integral connection; they may be mechanical connection or electrical connection; they may be direct connection, or indirect connection via an intermediate medium, or internal communication between two units; they may be wireless connection or wired connection. For those skilled in the art, the specific meaning of the aforementioned terms in the present invention can be understood according to specific situations thereof.

Furthermore, the technical features which the embodiments of the present invention provided bellow refer to can be combined with each other as long as no conflict is constituted.

Compared with a conventional terminal equipment, a mobile communication terminal has a radio frequency module, which is a prominent characteristic thereof. The module is large current and high power consumption module, and the starting or stopping of working of the module may cause a large fluctuation of battery voltage, having impact on the accuracy of measurement of quantity of electric charge of battery, thus, there is a need of making a compensation to battery voltage measured by the voltage measuring module in the mobile communication equipment, so as to ensure the accuracy of estimation of quantity of electric charge of battery according to the relation curve between the quantity of electric charge of battery and the battery voltage. In this context, the mobile communication terminal equipments include, but are not limited to, a cell phone, an interphone, a tablet computer, a lap top and etc.

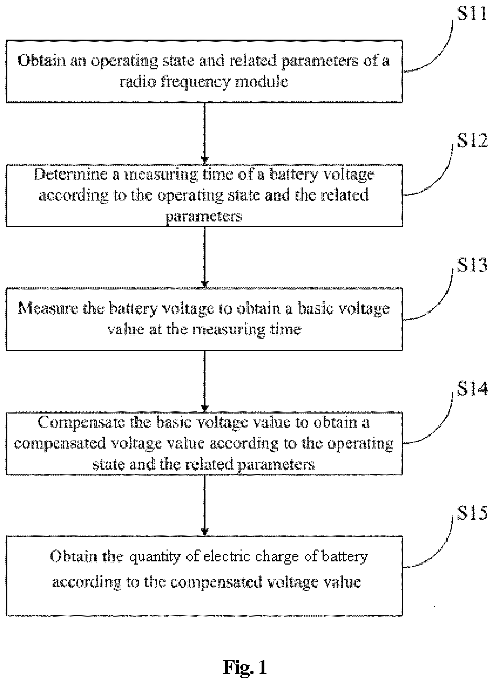

In order to accurately measure the quantity of electric charge of battery of mobile communication terminal equipment, embodiments of the present invention provide a method for measuring the quantity of electric charge of battery of mobile communication terminal equipment, and as shown in Fig. 1, the method includes the following steps:
S11: obtaining an operating state and related parameters of a radio frequency module. The operating state and the related parameters of the radio frequency module can be obtained through a micro-processor of the mobile communication terminal equipment. Generally, the radio frequency module may be a radio frequency transceiver consisting of a receiving unit and a transmitting unit which are independent with respect to each other. For a radio frequency transceiver, the operating state needed to be obtained includes an operating state S_{TX} of the transmitting unit of the radio frequency transceiver, namely in an activated state or an idle state, and an operating state S_{RX} of the receiving unit, namely in an activated state or an idle state; and the related parameters needed to be obtained include a transmitting start time t_{TX}, a transmitting duration D_{TX} and a transmitting power P_{TX} of the transmitting unit in each transmitting time slot, and a receiving start time t_{RX}, a receiving duration D_{RX} and a receive gain G_{RX} of the receiving unit in each receiving time slot. Certainly, for some mobile communication terminal equipment, the radio frequency module may only have a transmitting unit or a receiving unit, and in this case, only the operating state and the related parameters of the transmitting unit or the receiving unit are obtained.
S12: determining a measuring time t_{VM} of a battery voltage according to the operating state and the related parameters of the radio frequency module. In order to compensate for the influence of the radio frequency module on the fluctuation of the battery voltage, the battery voltage needs to be measured when the radio frequency module is in operating state. In order to make the measurement result more accurate, as a preferred implementation scheme, the measuring time t_{VM} is selected to be the midpoint of the operating time period of the radio frequency module, and at this time, the influence of the radio frequency module on the fluctuation of the battery voltage is most stable. Certainly, the measuring time selected to be earlier or later is feasible as long as it is within the operating time period of the radio frequency module.
S13: measuring the battery voltage at the measuring time t_{VM} to obtain a basic voltage value V₀.
S14: compensating the basic voltage value V₀ according to the operating state and the related parameters of the radio frequency module to obtain a compensated voltage value V_{C}.
S15: obtaining the quantity of electric charge of battery according to the compensated voltage value. This step is the same as a conventional voltage measurement method, namely the quantity of electric charge of battery Q_{C}=f(V_{C}) is calculated according to the obtained voltage value and the relation curve Q=f(V) between the quantity of electric charge of battery and the battery voltage.

According to a method for measuring the quantity of electric charge of battery of the mobile communication terminal equipment, provided by the embodiments of the present invention, a measuring time of the battery voltage is determined according to the operating state and the related parameters of the radio frequency module, a basic voltage value is obtained by measuring at the measuring time, and a compensated voltage value is obtained according to the operating state and the related parameters of the radio frequency module to compensate the influence of the radio frequency module on the fluctuation of the battery voltage, so that the quantity of electric charge of battery of the mobile communication terminal equipment can be accurately obtained.

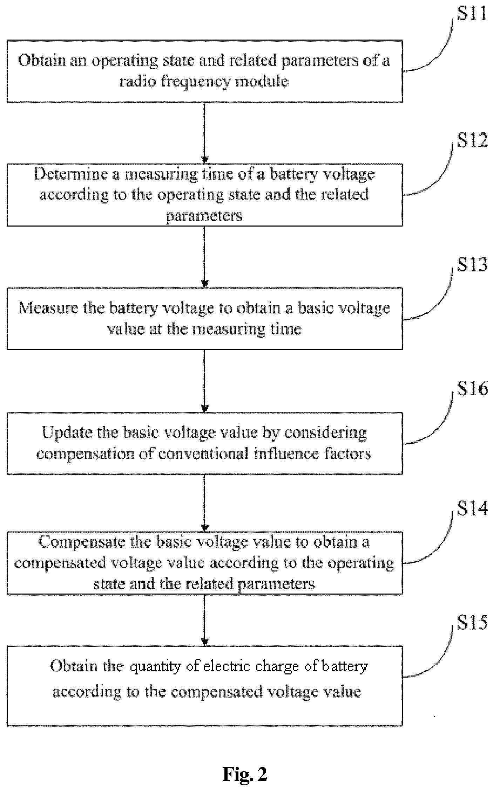

Fig. 2 shows a preferred embodiment of the method for measuring the quantity of electric charge of battery of the mobile communication terminal equipment according to the embodiments of the present invention, and in comparison with the method for measuring the quantity of electric charge of battery of the mobile communication terminal equipment in Fig. 1, S16: updating the basic voltage value according to conventional influence factors is added between S13 and S14 of the method.

In this step, any method for measuring the quantity of electric charge of battery of common terminal equipment in the prior art may be adopted to compensate for the influences of the factors such as an environment temperature, battery aging, backlight intensity, processor frequency on the battery voltage. The mobile communication terminal equipment also has power consuming equipment such as a display backlight, a central processing unit (CPU), a graphics processing unit (GPU) as those in the common terminal equipment, and the power consuming equipment and the factors including the environment temperature, battery aging and the like will also cause fluctuation to the battery voltage of the mobile communication terminal equipment, therefore, the influences of these factors on the battery voltage are compensated in the present embodiment, and the quantity of electric charge of battery of the mobile communication terminal equipment can be measured more accurately.

Hereinafter, the steps of determining the measuring time of the battery voltage and compensating the basic voltage value are further described in detail by taking that the radio frequency is a radio frequency transceiver as an example.

The step of determining the measuring time of the battery voltage may be divided into the following four conditions:
1) when the operating state S_{TX} of the transmitting unit of the radio frequency transceiver, received by the microprocessor, represents that the transmitting unit of the radio frequency transceiver is ready to transmit a signal, the microprocessor calculates the measuring time t_{VM} of the battery voltage for each transmitting time slot respectively, where t_{TX}<t_{VM}<t_{TX}+D_{TX}, namely the measuring time t_{VM} is within the operating time period of the radio frequency module, and preferably, t_{VM}=t_{TX}+D_{TX}/2, namely the measuring time t_{VM} is the midpoint of the operating time period of the transmitting module of the radio frequency module.
2) when the operating state S_{RX} of the receiving unit of the radio frequency transceiver, received by the microprocessor, represents that the receiving unit of the radio frequency transceiver is ready to receive a signal, the microprocessor calculates the measuring time t_{VM} of the battery voltage for each transmitting time slot respectively, where t_{RX}<t_{VM}<t_{RX}+D_{RX}, namely the measuring time t_{VM} is within the operating time period of the radio frequency module, and preferably, t_{VM}=t_{RX}+D_{RX}/2, namely the measuring time t_{VM} is the midpoint of the operating time period of the receiving module of the radio frequency module.
3) when the operating states S_{TX} and S_{RX} of the radio frequency transceiver, received by the microprocessor, represent that the transmitting unit and the receiving unit of the radio frequency transceiver are ready to transmit and receive signals at the same time, the microprocessor calculates a first measuring time t_{VM1} of the battery voltage for each transmitting time slot respectively, calculates a second measuring time t_{VM2} of the battery voltage for each transmitting time slot respectively, determines the time order of the first measuring time t_{VM1} and the second measuring time t_{VM2}, and takes the earlier one of them as the measuring time of the battery voltage.
4) when the operating states S_{TX} and S_{RX} of the radio frequency transceiver, received by the microprocessor, represent that the radio frequency transceiver does not have actions of transmitting and receiving signals, at that moment, the radio frequency transceiver is in an idle state and is very low in power consuming, the influence on the fluctuation of the battery voltage can be ignored, and in this case, the method for measuring the quantity of electric charge of battery is the same as that of a common terminal equipment in the prior art.

Correspondingly, the step of compensating the basic voltage value may also be divided into the following four conditions:
1) when the basic voltage value V₀ is obtained when the transmitting unit of the radio frequency transceiver is in operation, V_{C}=V₀+ΔV_{TX}(P_{TX}),where ΔV_{TX}(P_{TX}) represents a compensation voltage related to a transmitting power P_{TX}, and preferably a relation table showing that ΔV_{TX} corresponds to P_{TX} can be pre-stored in a memory of the mobile communication terminal equipment, so that the compensation voltage can be obtained very easily in use by searching the table.
2) when the basic voltage value V₀ is obtained when the receiving unit of the radio frequency transceiver is in operation, V_{C}=V₀+ΔV_{RX}(G_{RX}),where ΔV_{RX}(G_{RX}) represents a compensation voltage related to a receive gain G_{RX}, and in the same way, preferably a relation table showing that ΔV_{RX} corresponds to G_{RX} can be pre-stored in a memory of the mobile communication terminal equipment, so that the compensation voltage can be obtained very easily in use by searching the table.
3) when the basic voltage value V₀ is obtained when the transmitting unit and the receiving unit of the radio frequency transceiver are in operation, V_{C}=V₀+ΔV_{TX}(P_{TX})+ΔV_{RX}(G_{RX}), where ΔV_{TX}(P_{TX}) represents a compensation voltage related to a transmitting power P_{TX}, ΔV_{RX}(G_{RX}) represents a compensation voltage related to a receive gain G_{RX}, and in the same way, preferably a relation table showing that ΔV_{TX} corresponds to P_{TX} and ΔV_{RX} corresponds to G_{RX} can be pre-stored in a memory of the mobile communication terminal equipment, so that the compensation voltage can be obtained very easily in use by searching the table.
4) when the basic voltage value V₀ is obtained when both the transmitting unit and the receiving unit of the radio frequency transceiver are not in operation, at that moment, the radio frequency transceiver is in an idle state and is very low in power consumption, the influence on the fluctuation of the battery voltage can be ignored, and in this case, the basic voltage value V₀ does not need to be subjected to compensation of the factor of the radio frequency transceiver, namely V_{C}=V₀.

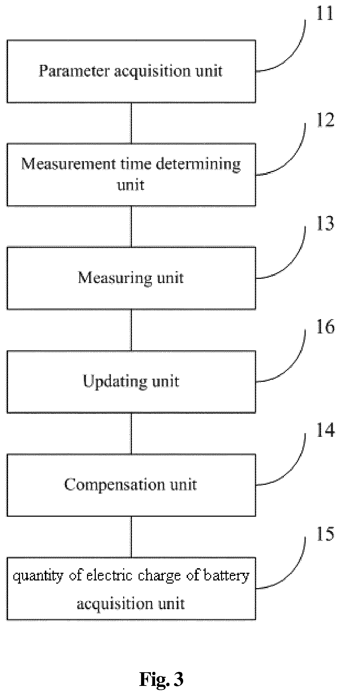

Referring to Fig. 3, the embodiments of the present invention also provides a system for measuring quantity of electric charge of battery of mobile communication terminal equipment, including:
a parameter obtaining unit 11, for obtaining an operating state and related parameters of a radio frequency module;
a measuring time determining unit 12, for determining a measuring time of a battery voltage according to the operating state and the related parameters;
a measuring unit 13, for measuring the battery voltage to obtain a basic voltage value at the measuring time;
a compensating unit 14, for compensating the basic voltage value to obtain a compensated voltage value according to the operating state and the related parameters; and
a quantity of electric charge of battery obtaining unit 15, for obtaining the quantity of electric charge of battery according to the compensated voltage value.

The further detailed description of each of the units are the same as the previous embodiment, and is not mentioned herein. According to the system for measuring the quantity of electric charge of battery of the mobile communication terminal equipment, provided by embodiments of the present invention, a measuring time of the battery voltage is determined according to the operating state and the related parameters of the radio frequency module, a basic voltage value is obtained by measuring at the measuring time, and a compensated voltage value is obtained according to the operating state and the related parameters of the radio frequency module to compensate the influence of the radio frequency module on the fluctuation of the battery voltage, so that the quantity of electric charge of battery of the mobile communication terminal equipment can be accurately obtained.

As a preferred embodiment, the system for measuring quantity of electric charge of battery of mobile communication terminal equipment also includes an updating unit 16, for, between measuring the battery voltage by the measuring unit 13 to obtain a basic voltage value and compensating the basic voltage value by the compensating unit 14 to obtain a compensated voltage value, updating the basic voltage value according to conventional influence factors.

By adaptation of the updating unit 16, it is able to compensate the fluctuation of the quantity of electric charge of battery caused by the factors such the display backlight, a central processing unit (CPU), a graphics processing unit (GPU) as those in the common terminal equipment, and the power consuming equipment and other factors including the environment temperature, battery aging and the like, so that the quantity of electric charge of battery of the mobile communication terminal equipment can be measured more accurately.

The system for measuring quantity of electric charge of battery of mobile communication terminal equipment of the following embodiment of the present invention is further described in detail, wherein, the radio frequency module of this embodiment is a radio frequency transceiver.

As a preferred embodiment, the measuring time determining unit 12 includes:
a first determining unit, for, when the operating state indicates that a transmitting unit of the radio frequency transceiver is ready to transmit a signal, calculating the measuring time t_{VM} (t_{TX}<t_{VM}<t_{TX}+D_{TX}) of the battery voltage for each transmitting time slot respectively, wherein t_{TX} represents the transmitting start time of each transmitting time slot, and D_{TX} represents a transmitting duration;
a second determining unit, for, when the operating state indicates that a receiving unit of the radio frequency transceiver is ready to receive a signal, calculating the measuring time t_{VM} (t_{RX}<t_{VM}<t_{TX}+D_{RX}) of the battery voltage for each transmitting time slot, wherein t_{RX} represents the receiving start time of each receiving time slot, and D_{RX} represents a receiving duration; and
a third determining unit, for, when the operating state indicates that the transmitting unit and the receiving unit of the radio frequency transceiver are ready to respectively transmit and receive signals at the same time, calculating a first measuring time t_{VM1} (t_{TX}<t_{VM1}<t_{TX}+D_{TX}) of the battery voltage for each transmitting time slot calculating a second measuring time t_{VM2} (t_{RX}<t_{VM2}<t_{TX}+D_{RX}) of the battery voltage for each transmitting time slot, determining the time order of the first measuring time t_{VM1} and the second measuring time t_{VM2}, and taking the earlier one of them as the measuring time of the battery voltage;
a fourth determining unit, when the working state indicates the ratio frequency transceiver does not send or receive signal and the ratio frequency transceiver is in idle state, having low power consumption; the impact caused by the fluctuation of battery voltage can be ignored; in this circumstance, the way of measuring quantity of electric charge of battery is the same as that for general terminal equipment of prior arts.

As a preferred embodiment, the compensating unit 14 includes:
a first compensating subunit, for, when the basic voltage value is obtained under the condition that the transmitting unit of the radio frequency transceiver is in operation, determining the compensated voltage value V_{C}=V₀+ΔV_{TX}(P_{TX});
a second compensating subunit, for, when the basic voltage value is obtained under the condition that the receiving unit of the radio frequency transceiver is in operation, determining the compensated voltage value V_{C}=V₀+ΔV_{RX}(G_{RX}); and
a third compensating subunit, for, when the basic voltage value is obtained under the condition that both of the transmitting unit and the receiving unit of the radio frequency transceiver are in operation, determining the compensated voltage value V_{C}=V₀+ΔV_{TX}(P_{TX}) +ΔV_{RX}(G_{RX}); wherein, V₀ represents the basic voltage value, ΔV_{TX}(P_{TX}) represents a compensation voltage related to a transmitting frequency P_{TX} of the radio frequency transceiver, and ΔV_{RX}(G_{RX}) represents a compensation voltage related to a receive gain G_{RX} of the radio frequency transceiver;
a fourth compensating unit, when the basic voltage value is obtained under the condition that both of the transmitting unit and the receiving unit of the radio frequency transceiver both are not in operation and the ratio transceiver is in idle state, having low power consumption, and the impact by fluctuation of battery voltage can be ignored, in this circumstance, there is no need of making a compensation to the basic voltage value V₀ due to the factor of ratio frequency transceiver, i.e. Vc= V₀

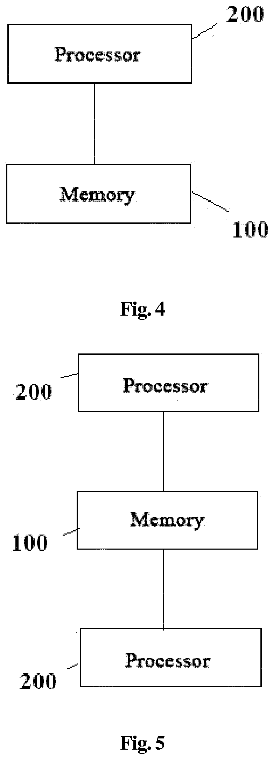

The embodiment of the present invention further provides a system for measuring quantity of electric charge of battery of mobile communication terminal equipment, including: one or more processors 200, a memory 100, one or more programs, stored in the memory 100, and when executed by the one or more processors 200 perform the following steps of obtaining an operating state and related parameters of a radio frequency module; determining a measuring time of a battery voltage according to the operating state and the related parameters; measuring the battery voltage to obtain a basic voltage value at the measuring time; compensating the basic voltage value to obtain a compensated voltage value according to the operating state and the related parameters; and obtaining the quantity of electric charge of battery according to the compensated voltage value. The system may include one processor 200 as illustrated in Fig. 4, or two processors 200 as illustrated in Fig. 5.

In the system of this embodiment, preferably, the radio frequency module is a radio frequency transceiver.

In the system of this embodiment, preferably, the step of determining the measuring time of the battery voltage according to the operating state and the related parameters includes: when the operating state indicates that a transmitting unit of the radio frequency transceiver is ready to transmit a signal, calculating the measuring time t_{VM} (t_{TX}<t_{VM}<t_{TX}+D_{TX}) of the battery voltage for each transmitting time slot respectively, wherein t_{TX} represents the transmitting start time of each transmitting time slot, and D_{TX} represents a transmitting duration; when the operating state indicates that a receiving unit of the radio frequency transceiver is ready to receive a signal, calculating the measuring time t_{VM} (t_{RX}<t_{VM}<t_{TX}+D_{RX}) of the battery voltage for each transmitting time slot, wherein t_{RX} represents the receiving start time of each receiving time slot, and D_{RX} represents a receiving duration; and when the operating state indicates that the transmitting unit and the receiving unit of the radio frequency transceiver are ready to respectively transmit and receive signals at the same time, calculating a first measuring time t_{VM1} (t_{TX}<t_{VM1}<t_{TX}+D_{TX}) of the battery voltage for each transmitting time slot calculating a second measuring time t_{VM2} (t_{RX}<t_{VM2}<t_{TX}+D_{RX}) of the battery voltage for each transmitting time slot, determining the time order of the first measuring time t_{VM1} and the second measuring time t_{VM2}, and taking the earlier one of them as the measuring time of the battery voltage.

In the system of this embodiment, preferably, the step of compensating the basic voltage value to obtain the compensated voltage value includes: when the basic voltage value is obtained under the condition that the transmitting unit of the radio frequency transceiver is in operation, determining the compensated voltage value V_{C}=V₀+ΔV_{TX}(P_{TX}); when the basic voltage value is obtained under the condition that the receiving unit of the radio frequency transceiver is in operation, determining the compensated voltage value V_{C}=V₀+ΔV_{RX}(G_{RX}); and when the basic voltage value is obtained under the condition that both of the transmitting unit and the receiving unit of the radio frequency transceiver are in operation, determining the compensated voltage value V_{C}=V₀+ΔV_{TX}(P_{TX}) +ΔV_{RX}(G_{RX}), wherein V₀ represents the basic voltage value, ΔV_{TX}(P_{TX}) represents a compensation voltage related to a transmitting frequency P_{TX} of the radio frequency transceiver, and ΔV_{RX}(G_{RX}) represents a compensation voltage related to a receive gain G_{RX} of the radio frequency transceiver.

In the system of this embodiment, preferably, between the step of measuring the battery voltage to obtain a basic voltage value and the step of compensating the basic voltage value to obtain a compensated voltage value, the programs further perform the step of updating the basic voltage value according to conventional influence factors.

It should be appreciated by those skilled in the art that the embodiments of the present invention may be provided as methods, devices or computer program products. Therefore, the present invention may adopt the form of a complete hardware embodiment, a complete software embodiment or an embodiment of software and hardware in combination. Moreover, the present invention may adopt the form of a computer program product implemented on one or more computer-useable storage media (including but not limited to a magnetic disk memory, a CD-ROM, an optic memory, and the like) containing computer-usable program codes.

The present invention is described with reference to flow charts and/or block diagrams of the methods, devices (systems) and computer program products according to the embodiments of the present invention. It should be understood that each flow step and/or block in the flow charts and/or block diagrams as well as combination of flow steps and/or blocks in the flow charts and/or block diagrams may be implemented by computer program instructions. These computer program instructions may be loaded onto a general computer, a dedicated computer, an embedded processor or a processor of other programmable data processing devices to produce a machine, so that a device for achieving functions designated in one or more flow steps of the flow charts and/or in one or more blocks of the block diagrams is produced by means of the instructions executed by the computer or the processor of other programmable data processing devices.

These computer program instructions may also be stored in a computer-readable memory capable of guiding the computer or other programmable data processing devices to work in a specific mode, so as to produce a manufactured product including an instruction device by means of the instructions stored in the computer-readable memory, and the instruction device implements the functions designated in one or more flow steps of the flow charts and/or in one or more blocks of the block diagrams.

These computer program instructions may also be loaded onto a computer or other programmable data processing devices, so that a series of operation steps are executed on the computer or other programmable devices to produce processing implemented by the computer, and the instructions executed on the computer or other programmable data processing devices provide steps for implementing the functions designated in one or more flow steps of the flow charts and/or in one or more blocks of the block diagrams.

Obviously, it should be noted that the above embodiments are merely used for illustrating rather than limiting the technical solutions of the present application; although the present application is illustrated in detail with reference to the aforementioned embodiments, it should be understood by those of ordinary skill in the art that modifications may still be made on the technical solutions disclosed in the aforementioned respective embodiments, or equivalent substitutions may be made to part of technical characteristics thereof; and these modifications or substitutions shall not make the nature of the corresponding technical solutions depart from the spirit and scope of the technical solutions of the respective embodiments of the present disclosure.

## Claims

1. A method for measuring quantity of electric charge of battery of mobile communication terminal equipment, **characterized in** comprising:
obtaining an operating state and related parameters of a radio frequency module;
determining a measuring time of a battery voltage according to the operating state and the related parameters;
measuring the battery voltage to obtain a basic voltage value at the measuring time;
compensating the basic voltage value to obtain a compensated voltage value according to the operating state and the related parameters; and
obtaining the quantity of electric charge of battery according to the compensated voltage value.

2. The method according to claim 1, **characterized in that** the radio frequency module is a radio frequency transceiver.

3. The method according to claim 2, **characterized in that** the step of determining the measuring time of the battery voltage according to the operating state and the related parameters comprises:
when the operating state indicates that a transmitting unit of the radio frequency transceiver is ready to transmit a signal, calculating the measuring time t_{VM} (t_{TX}<t_{VM}<t_{TX}+D_{TX}) of the battery voltage for each transmitting time slot respectively, wherein t_{TX} represents the transmitting start time of each transmitting time slot, and D_{TX} represents a transmitting duration;
when the operating state indicates that a receiving unit of the radio frequency transceiver is ready to receive a signal, calculating the measuring time t_{VM} (t_{RX}<t_{VM}<t_{TX}+D_{RX}) of the battery voltage for each transmitting time slot, wherein t_{RX} represents the receiving start time of each receiving time slot, and D_{RX} represents a receiving duration; and
when the operating state indicates that the transmitting unit and the receiving unit of the radio frequency transceiver are ready to respectively transmit and receive signals at the same time, calculating a first measuring time t_{VM1} (t_{TX}<t_{VM1}<t_{TX}+D_{TX}) of the battery voltage for each transmitting time slot , calculating a second measuring time t_{VM2} (t_{RX}<t_{VM2}<t_{TX}+D_{RX}) of the battery voltage for each transmitting time slot, determining the time order of the first measuring time t_{VM1} and the second measuring time t_{VM2}, and taking the earlier one of them as the measuring time of the battery voltage.

4. The method according to claim 2 or 3, **characterized in that** the step of compensating the basic voltage value to obtain the compensated voltage value comprises:
when the basic voltage value is obtained under the condition that the transmitting unit of the radio frequency transceiver is in operation, determining the compensated voltage value V_{C}=V₀+ΔV_{TX}(P_{TX});
when the basic voltage value is obtained under the condition that the receiving unit of the radio frequency transceiver is in operation, determining the compensated voltage value V_{C}=V₀+ΔV_{RX}(G_{RX}); and
when the basic voltage value is obtained under the condition that both of the transmitting unit and the receiving unit of the radio frequency transceiver are in operation, determining the compensated voltage value V_{C}=V₀+ΔV_{TX}(P_{TX}) +ΔV_{RX}(G_{RX}),
wherein V₀ represents the basic voltage value, ΔV_{TX}(P_{TX}) represents a compensation voltage related to a transmitting frequency P_{TX} of the radio frequency transceiver, and ΔV_{RX}(G_{RX}) represents a compensation voltage related to a receive gain G_{RX} of the radio frequency transceiver.

5. The method according to any one of claims 1-4, **characterized in that** between the step of measuring the battery voltage to obtain a basic voltage value and the step of compensating the basic voltage value to obtain a compensated voltage value, the method further comprises:
updating the basic voltage value according to conventional influence factors.

6. A system for measuring quantity of electric charge of battery of mobile communication terminal equipment, **characterized in** comprising:
a parameter obtaining unit, for obtaining an operating state and related parameters of a radio frequency module;
a measuring time determining unit, for determining a measuring time of a battery voltage according to the operating state and the related parameters;
a measuring unit, for measuring the battery voltage to obtain a basic voltage value at the measuring time;
a compensating unit, for compensating the basic voltage value to obtain a compensated voltage value according to the operating state and the related parameters; and
a quantity of electric charge of battery obtaining unit, for obtaining the quantity of electric charge of battery according to the compensated voltage value.

7. The system according to claim 6, **characterized in that** the radio frequency module is a radio frequency transceiver.

8. The system according to claim 7, **characterized in that** the measuring time determining unit comprises:
a first determining unit, for, when the operating state indicates that a transmitting unit of the radio frequency transceiver is ready to transmit a signal, calculating the measuring time t_{VM} (t_{TX}<t_{VM}<t_{TX}+D_{TX}) of the battery voltage for each transmitting time slot respectively, wherein t_{TX} represents the transmitting start time of each transmitting time slot, and D_{TX} represents a transmitting duration;
a second determining unit, for, when the operating state indicates that a receiving unit of the radio frequency transceiver is ready to receive a signal, calculating the measuring time t_{VM} (t_{RX}<t_{VM}<t_{TX}+D_{RX}) of the battery voltage for each transmitting time slot, wherein t_{RX} represents the receiving start time of each receiving time slot, and D_{RX} represents a receiving duration; and
a third determining unit, for, when the operating state indicates that the transmitting unit and the receiving unit of the radio frequency transceiver are ready to respectively transmit and receive signals at the same time, calculating a first measuring time t_{VM1} (t_{TX}<t_{VM1}<t_{TX}+D_{TX}) of the battery voltage for each transmitting time slot calculating a second measuring time t_{VM2} (t_{RX}<t_{VM2}<t_{TX}+D_{RX}) of the battery voltage for each transmitting time slot, determining the time order of the first measuring time t_{VM1} and the second measuring time t_{VM2}, and taking the earlier one of them as the measuring time of the battery voltage.

9. The system according to claim 7 or 8, **characterized in that** compensating unit comprises:
a first compensating subunit, for, when the basic voltage value is obtained under the condition that the transmitting unit of the radio frequency transceiver is in operation, determining the compensated voltage value V_{C}=V₀+ΔV_{TX}(P_{TX});
a second compensating subunit, for, when the basic voltage value is obtained under the condition that the receiving unit of the radio frequency transceiver is in operation, determining the compensated voltage value V_{C}=V₀+ΔV_{RX}(G_{RX}); and
a third compensating subunit, for, when the basic voltage value is obtained under the condition that both of the transmitting unit and the receiving unit of the radio frequency transceiver are in operation, determining the compensated voltage value V_{C}=V₀+ΔV_{TX}(P_{TX}) +ΔV_{RX}(G_{RX}),
wherein, V₀ represents the basic voltage value, ΔV_{TX}(P_{TX}) represents a compensation voltage related to a transmitting frequency P_{TX} of the radio frequency transceiver, and ΔV_{RX}(G_{RX}) represents a compensation voltage related to a receive gain G_{RX} of the radio frequency transceiver.

10. The system according to any one of claims 6-9, **characterized in that** an updating unit, for, between the step of measuring the battery voltage to obtain a basic voltage value and the step of compensating the basic voltage value to obtain a compensated voltage value, updating the basic voltage value according to conventional influence factors.

11. A system for measuring quantity of electric charge of battery of mobile communication terminal equipment, **characterized in** comprising one or more processors, a memory, one or more programs, stored in the memory, and when executed by the one or more processors perform the following steps of
obtaining an operating state and related parameters of a radio frequency module;
determining a measuring time of a battery voltage according to the operating state and the related parameters;
measuring the battery voltage to obtain a basic voltage value at the measuring time;
compensating the basic voltage value to obtain a compensated voltage value according to the operating state and the related parameters; and
obtaining the quantity of electric charge of battery according to the compensated voltage value.

12. The system according to claim 11, **characterized in that** the radio frequency module is a radio frequency transceiver.

13. The system according to claim 12, **characterized in that** the step of determining the measuring time of the battery voltage according to the operating state and the related parameters comprises:
when the operating state indicates that a transmitting unit of the radio frequency transceiver is ready to transmit a signal, calculating the measuring time t_{VM} (t_{TX}<t_{VM}<t_{TX}+D_{TX}) of the battery voltage for each transmitting time slot respectively, wherein t_{TX} represents the transmitting start time of each transmitting time slot, and D_{TX} represents a transmitting duration;
when the operating state indicates that a receiving unit of the radio frequency transceiver is ready to receive a signal, calculating the measuring time t_{VM} (t_{RX}<t_{VM}<t_{TX}+D_{RX}) of the battery voltage for each transmitting time slot, wherein t_{RX} represents the receiving start time of each receiving time slot, and D_{RX} represents a receiving duration; and
when the operating state indicates that the transmitting unit and the receiving unit of the radio frequency transceiver are ready to respectively transmit and receive signals at the same time, calculating a first measuring time t_{VM1} (t_{TX}<t_{VM1}<t_{TX}+D_{TX}) of the battery voltage for each transmitting time slot calculating a second measuring time t_{VM2} (t_{RX}<t_{VM2}<t_{TX}+D_{RX}) of the battery voltage for each transmitting time slot, determining the time order of the first measuring time t_{VM1} and the second measuring time t_{VM2}, and taking the earlier one of them as the measuring time of the battery voltage.

14. The system according to claim 12 or 13, **characterized in that** the step of compensating the basic voltage value to obtain the compensated voltage value comprises:
when the basic voltage value is obtained under the condition that the transmitting unit of the radio frequency transceiver is in operation, determining the compensated voltage value V_{C}=V₀+ΔV_{TX}(P_{TX});
when the basic voltage value is obtained under the condition that the receiving unit of the radio frequency transceiver is in operation, determining the compensated voltage value V_{C}=V₀+ΔV_{RX}(G_{RX}); and
when the basic voltage value is obtained under the condition that both of the transmitting unit and the receiving unit of the radio frequency transceiver are in operation, determining the compensated voltage value V_{C}=V₀+ΔV_{TX}(P_{TX}) +ΔV_{RX}(G_{RX}),
wherein V₀ represents the basic voltage value, ΔV_{TX}(P_{TX}) represents a compensation voltage related to a transmitting frequency P_{TX} of the radio frequency transceiver, and ΔV_{RX}(G_{RX}) represents a compensation voltage related to a receive gain G_{RX} of the radio frequency transceiver.

15. The system according to any one of claims 11-15, **characterized in that** between the step of measuring the battery voltage to obtain a basic voltage value and the step of compensating the basic voltage value to obtain a compensated voltage value, the programs further perform the step of:
updating the basic voltage value according to conventional influence factors.
